# EUROPEAN PATENT APPLICATION

(11) **EP 4 756 786 A1**
(43) Date of publication of application: **10.06.2026**
(21) Application number: 25219620.9
(22) Date of filing: 01.12.2025
(51) Int. Cl.: G09G 3/04, G09G 3/20, H10H 20/857, H10H 29/14

(54) **DISPLAY DEVICE**

(30) Priority: 09.12.2024 JP 2024214479
(71) Applicant: Alps Alpine Co., Ltd., Ota-ku, Tokyo 145-8501 (JP)
(72) Inventor: Kitamura, Kazuhiro, Iwaki-city, Fukushima (JP)
(74) Representative: Schmitt-Nilson Schraud Waibel Wohlfrom Patentanwälte Partnerschaft mbB

(57) **Abstract**

A display device includes: a plurality of light-emitting elements; and a circuit substrate with a surface configured for mounting the plurality of light-emitting elements. The plurality of light-emitting elements are arranged on the circuit substrate to form a fixed display pattern. Part or all of the plurality of light-emitting elements are connected in series via wires.

## Description

The present disclosure relates to a display device having multiple light-emitting elements positioned on a substrate. In particular, the present disclosure relates to a display device in which light-emitting elements such as micro light-emitting diodes (LEDs) are mounted on a circuit substrate.

In recent years, micro LEDs that enable direct display of images from light-emitting diodes have been under study. There are two types of systems for driving micro LED displays that show images: an active matrix system and a passive matrix system. The active matrix system requires a thin-film transistor (TFT) for each pixel to control the pixel on and off. Because LEDs are current-driven devices, the drive circuit tends to be more complex than that of liquid crystal display (LCD) devices. Furthermore, building a circuit that can drive every pixel individually requires a substantial capital investment, as do LCD displays (see, for example, Published Japanese Translation No. 2021-504752 of the PCT International Publication).

The present disclosure relates to a display device according to the appended claims. Embodiments are disclosed in the dependent claims.

The present disclosure according to an aspect provides a display device that includes: a plurality of light-emitting elements; and a circuit substrate with a surface configured for mounting the plurality of light-emitting elements. The plurality of light-emitting elements are arranged on the circuit substrate to form a fixed display pattern. Part or all of the plurality of light-emitting elements are connected in series via wires.
FIG. 1 shows an overall structure of a display device according to an embodiment of the present disclosure, and shows an example layout of light-emitting elements or pixels that form display patterns;
FIG. 2 shows an example in which display patterns are turned off and an example in which display patterns are turned on;
FIG. 3 shows an example layout of light-emitting elements forming a display pattern;
FIG. 4A is a top view of an exemplary 4-terminal LED package;
FIG. 4B is a bottom view of an exemplary 4-terminal LED package;
FIG. 4C is a diagram showing a connection of common-cathode R, G, and B light-emitting elements;
FIG. 4D is a comparative example in which a display pattern is formed with 4-terminal LED packages;
FIG. 5 is a diagram showing an example layout of LED chips according to a preferred embodiment of the present disclosure;
FIG. 6 is a diagram for explaining improvements and advantages that the layout of LED chips shown in FIG. 5 brings about;
FIG. 7 is a diagram showing an example layout of LED chips according to a preferred embodiment of the present disclosure;
FIG. 8 is a diagram showing an example wiring pattern that may be applied to the layout of LED chips shown in FIG. 7; and
FIG. 9 is a bottom view of an exemplary 6-terminal LED package.

According to the passive matrix system mentioned earlier, pixels are divided into groups and driven according to the time allowed for each divided group, so that passive elements need not be provided on a panel and images can be displayed using wiring patterns alone. On the other hand, when the resolution of images increases, each pixel is lit for a shorter period of time, resulting in reduced overall brightness level. For example, assuming that an image has a resolution of 256 x 64 pixels, each pixel is lit only for 1/64th of the time. In this case, despite the high resolution, the overall brightness level is too low and makes the display device practically useless.

When used as a system for driving a micro LED display to show images, the active matrix system requires complex drive circuitry and significant capital investment, whereas the passive matrix system suffers from a critical drop in brightness level at high resolutions.

The present disclosure aims to address the above problems with existing matrix systems by providing a display device that can drive light-emitting elements such as micro LEDs based on a non-matrix drive system.

For example, according to the present disclosure, multiple light-emitting elements are connected in series for driving, so that, for example, the drive circuit is made simple compared to one for the active matrix system, and the drop in brightness level due to high resolutions can be avoided, as occurs when the passive matrix system is used. Furthermore, connecting multiple light-emitting elements in series enables the use of a single-layer substrate, leading to reduced manufacturing costs of the display device.

Embodiments of the present disclosure will be described below with reference to the accompanying drawings.

The present disclosure provides a display device that mounts multiple light-emitting elements on a circuit substrate. In particular, the present disclosure provides a display device that drives light-emitting elements based on a non-matrix system. The light-emitting elements according to the present disclosure are, for example, RGB micro LEDs. The RGB micro LEDs may be individual chips or housed in a single package. The light-emitting elements are placed on a circuit substrate and form, for example, two-dimensional display patterns. The light-emitting elements are connected in series by wires, and their light emission is controlled by a drive circuit. Note that the drawings referred to in the following description contain exaggerated illustrations to help understand the present disclosure with ease and may not show the shapes, dimensions, etc. of devices and components accurately.

### [Embodiment]

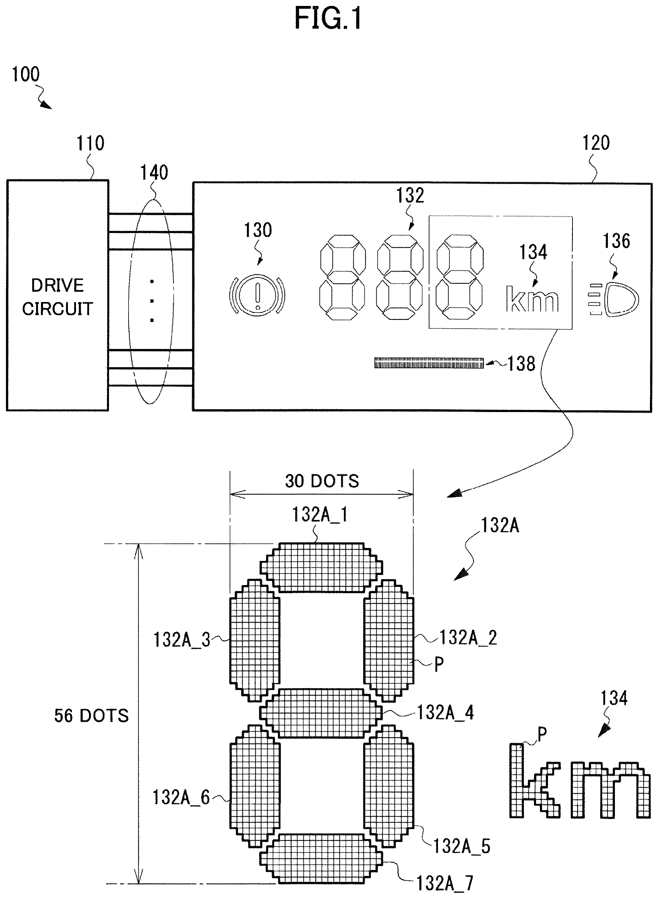

FIG. 1 is a block diagram showing an overall structure of a display device according to an embodiment of the present disclosure. As shown in FIG. 1, a display device 100 includes: a drive circuit 110; and a circuit substrate 120, on which multiple light-emitting elements are mounted.

The circuit substrate 120 may have, for example, a rectangular planar surface as shown in the FIG. 1, but this is by no means a limitation. The circuit substrate 120 may be made of, for example, glass, plastic, acrylic, polyimide, etc., but is not limited to these. The circuit substrate 120 may be a flexible, transparent substrate, for example. Wires are formed on a surface of the circuit substrate 120 to electrically connect the light-emitting elements with each other. These wires are electrically connected with the drive circuit 110 via drive wires 140. Although the drive wires 140 and the drive circuit 110 are shown separate from the circuit substrate 120 in FIG. 1, the drive wires 140 may be formed on the surface of the circuit substrate 120 with wires for the light-emitting elements, and the drive circuit 110 may be mounted on the circuit substrate 120.

The light-emitting element are, for example, micro-LEDs. When displaying a monochrome image, one pixel is composed of a micro-LED having one of the colors red (R), green (G), and blue (B). When displaying a color image, one pixel is composed of three micro-LEDs: an R_LED that emits red light; a G_LED that emits green light; and a B_LED that emits blue light.

The light-emitting elements are placed on the circuit substrate 120 such that, for example, two-dimensional shapes are formed thereon as fixed display patterns. In FIG. 1, the light-emitting elements mounted on the circuit substrate 120 form display patterns 130, 132, 134, 136, and 138. The display pattern 130 is an icon representing a power supply. The display pattern 132 is a three-digit number. The display pattern 134 is "km" (kilometer). The display pattern 136 is an icon representing a light. The display pattern 138 is a bar indicator showing the amount of fuel. The types, shapes, sizes, etc. of these display patterns are only examples and can be designed differently.

FIG. 1 shows an example layout of light-emitting elements forming one digit 132A, which is part of the display pattern 132, and the display pattern 134. The shape labeled "P" in the lower part of FIG. 1 is composed of multiple squares, each square being a light-emitting element or a pixel. The digit 132A is composed of seven segments 132A_1, 132A_2, 132A_3, 132A_4, 132A_5, 132A_6, and 132A_7. The light-emitting elements are arranged such that the seven segments each form a two-dimensional shape with a resolution of 56 vertical dots by 30 horizontal dots. In this example, one segment is composed of 160 light-emitting elements. In the event the segments show a color image, one segment is composed of 480 light-emitting elements.

The display pattern 134 is also two-dimensional shapes composed of light-emitting elements arranged at a resolution of 56 vertical dots by 30 horizontal dots. Furthermore, although not illustrated in FIG. 1, the other display patterns 130, 132, 136, and 138 are also two-dimensional shapes composed of light-emitting elements arranged at a resolution of 56 vertical dots by 30 horizontal dots.

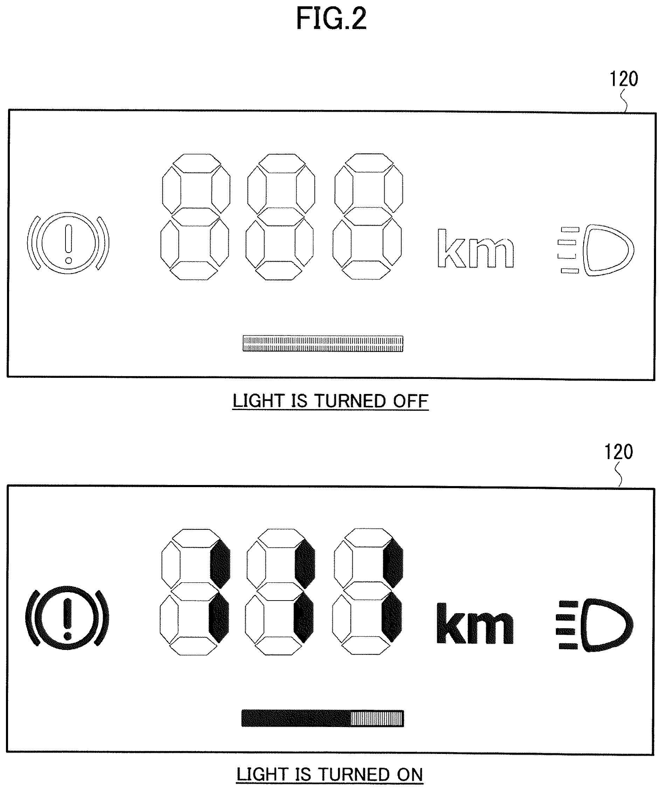

FIG. 2 shows: an example in which display patterns are turned off; and an example in which the display patterns are turned on. The display patterns 130, 134, 136, and 138 may be turned on at all times. Among the segments forming the display pattern 132, those that correspond to the number to be displayed are selected by the drive circuit 110, and the light-emitting elements forming the selected segments are turned on. In the example of FIG. 2, the display pattern 132 shows "111." These display patterns can change their color if the light-emitting elements include R_LEDs, G_LEDs, and B_LEDs.

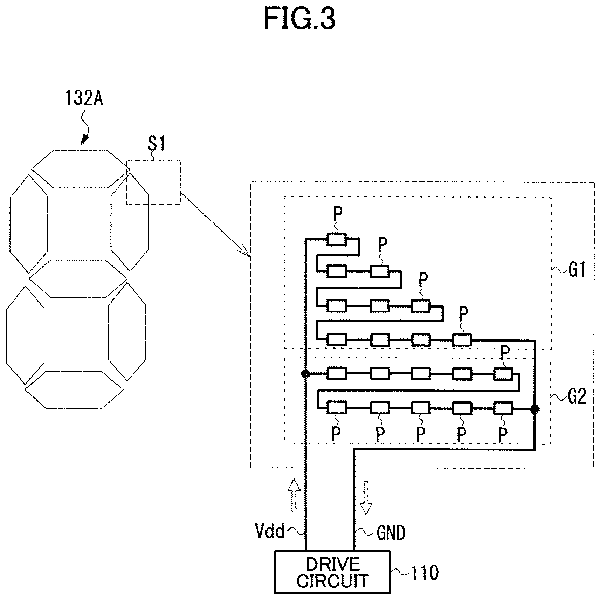

FIG. 3 schematically illustrates an example of how the light-emitting elements forming the part labeled "S1" in the segment 132A are wired. As shown in FIG. 3, multiple light-emitting elements P are arranged to form the two-dimensional shape or contour of the part S1 in the segment 132A. The light-emitting elements P are divided into a group G1 and a group G2, each group containing a certain number of light-emitting elements that are connected in series. A wire Vdd and a wire GND extend from the drive circuit 110, and the groups G1 and G2 are connected in parallel between these wires. The light-emitting elements in the groups G1 and G2 are connected in series by wires. The wires are routed in a single stroke so as not to cross each other. The drive circuit 110 supplies current to the light-emitting elements P in the groups G1 and G2 via the wire Vdd, lighting up all of the light-emitting elements P in the groups G1 and G2 together. If the user wants to drive the groups G1 and G2 separately, two pairs of wires Vdd and GND may be provided for the groups G1 and G2, connecting one pair to the group G1 and the other pair to the group G2.

As described above, multiple light-emitting elements may be connected in series to form fixed display patterns, and the light-emitting elements connected in series may be turned on and off all together. This makes it possible to realize a simple and low-cost drive circuit compared to ones used heretofore for the active matrix system and the passive matrix system, thereby reducing the capital investment required to manufacture the display device.

Next, a display device according to a more preferable embodiment of the present disclosure will be described. The following improvements should ideally be introduced when making a micro LED panel (i.e., circuit substrate with light-emitting elements mounted thereon).
(1) Wiring the circuit substrate in a single layer.
   Highly accurate and fine wiring is required. Use of a layered or multi-layer circuit substrate might result in creating spaces between layers, as well as cross-layer short circuits with other wires and other problems, eventually leading to increased difficulty in manufacturing and reduced yield.
(2) Reducing the number of interfaces with the drive circuit.
   A large number of micro LEDs need to be mounted and driven on the circuit substrate. The number of wires required to connect these micro LEDs in series (i.e., the number of drive wires 140), if too large, can be a constraint on design.
(3) Reducing Current.
   Thinner wires have greater wiring resistance, which lessens the current flow in the wires. On the other hand, micro-LEDs are current-driven devices, in which connecting a larger number of micro-LEDs in series results in greater current flow in the wires. To pass a large current, the wires must be large in width. This, however, makes it difficult to arrange micro-LEDs at small pitches. It is therefore more desirable to minimize the current flow in the wires.

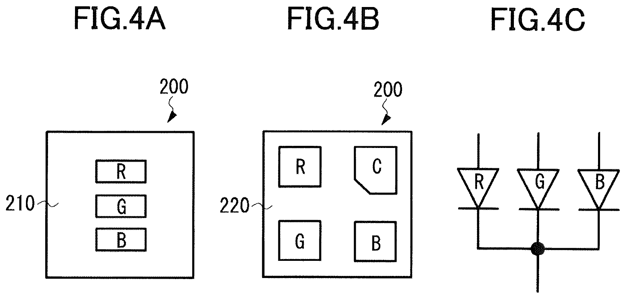

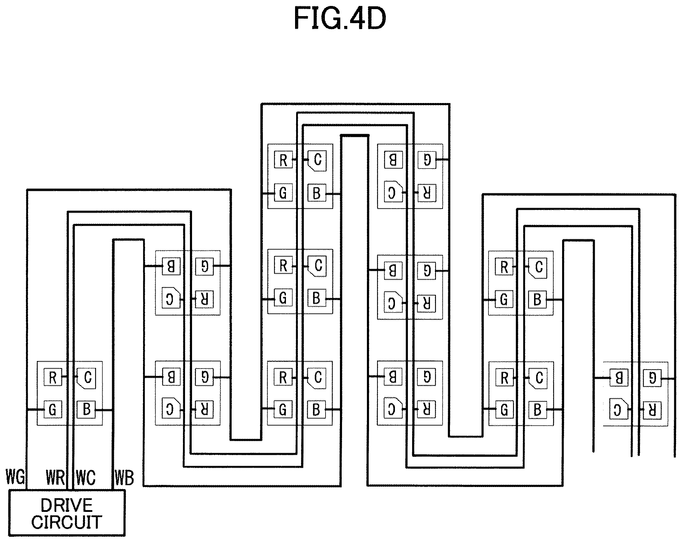

FIG. 4A to FIG. 4D show comparative examples of how a display pattern is formed using a 4-terminal LED package containing three RGB LEDs. FIG. 4A shows a top view of a 4-terminal LED package. FIG. 4B shows a bottom view of a 4-terminal LED package. FIG. 4C shows common-cathode electrical connections. FIG. 4D shows an example layout of 4-terminal LED packages.

As shown in FIG. 4A, a 4-terminal LED package 200 contains R, G, and B light-emitting parts on a top surface 210, and includes R, G, B, and C (common) electrodes, labeled "R," "G," "B," and "C," on a bottom surface 220. The electrode R is connected to the anode of the R LED. The electrode G is connected to the anode of the G LED. The electrode B is connected to the anode of the B LED. The electrode C is connected to the cathodes of the R, G, and B LEDs in common.

The 4-terminal LED packages 200 are arranged to form, for example, a display pattern's two-dimensional shape, as shown in FIG. 4D. To make the circuit substrate a single layer here, the R, G, B, and C wires (i.e., WR, WG, WB, and WC) on the circuit substrate must be drawn in a single stroke. In other words, the R, G, B, and C wires must be drawn such that they do not cross each other. So, as shown in FIG. 4D, 4-terminal LED packages 200 are positioned such that the odd-numbered columns and the even-numbered columns are reversed in orientation by 180 degrees. The R, G, B, and C wires (WR, WG, WG, and WC) from the drive circuit 110 are connected in series, to the R, G, B, and C electrodes of the 4-terminal LED packages 200 arranged thus, without crossing each other.

However, in these 4-terminal LED packages 200, the R, G, and B LEDs share a cathode in common, and so the R, G, and B LEDs in any one LED package are connected in parallel, increasing the current flow in that LED package. As a result of this, the difference in applied voltage between the start and end of 4-terminal LED packages 200 connected in series increases, leading to uneven brightness levels.

In view of the above, according to embodiments, display patterns are formed by using independent R, G, and B LED chips or by using 6-terminal LED packages (described later), instead of by using 4-terminal LED packages.

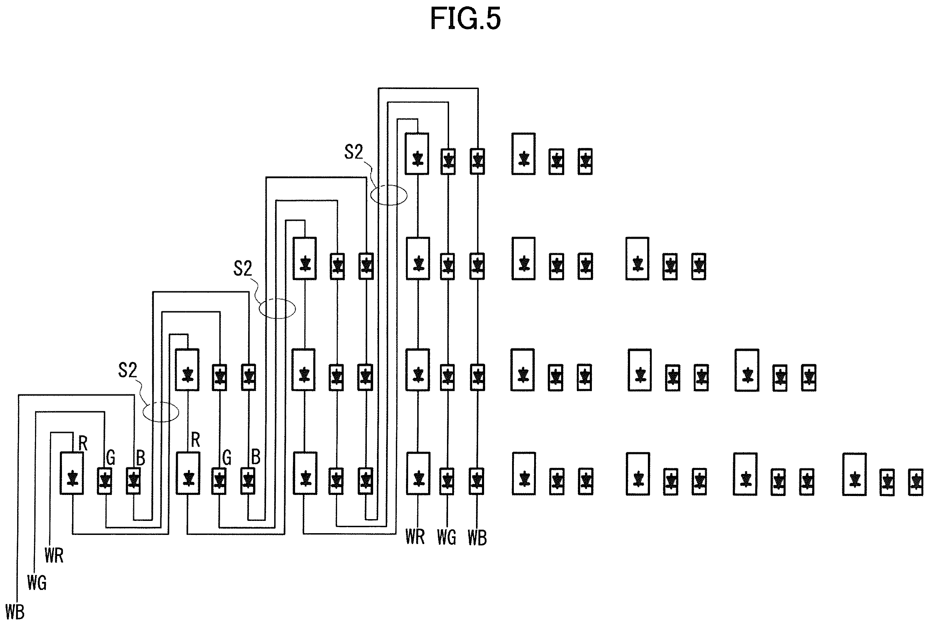

FIG. 5 shows an example layout of LED chips forming a display pattern. The R, G, and B LED chips each have an anode electrode and a cathode electrode. The R, G, and B LED chips are all arranged such that the orientation of the anode and cathode electrodes coincides with the column direction of the display pattern. For example, referring to FIG. 5, a wire WR from the drive circuit 110 is connected to the anode electrode of an R LED chip, and its cathode electrode is electrically connected, by the wire WR, to the cathode electrode of an R LED chip that is positioned next thereto. Likewise, a wire WG from the drive circuit 110 is connected to the anode electrode of a G LED chip, and its cathode electrode is electrically connected, by the wire WG, to the cathode electrode of a G LED chip positioned next thereto. A wire WB from the drive circuit 110 is connected to the anode electrode of a B LED chip, and its cathode electrode is electrically connected, by the wire WB, to the cathode electrode of a B LED chip positioned next thereto. The R, G, and B LED chips are connected in series thus and form a display pattern together.

If all the LED chips were aligned in the column direction, the wires WR, WG, and WB could be laid out in a single stroke without crossing each other, as shown in FIG. 5, but then the three wires WR, WG, and WB would have to be folded back within the narrow spaces S2 formed between neighboring columns. This would create new constraints: the wires need to be laid out in increased length, and the wires' width needs to be narrower. These constraints make it extremely difficult to layout the wires on a single-layer substrate because the wires need to have a certain width to ensure stable current capacity.

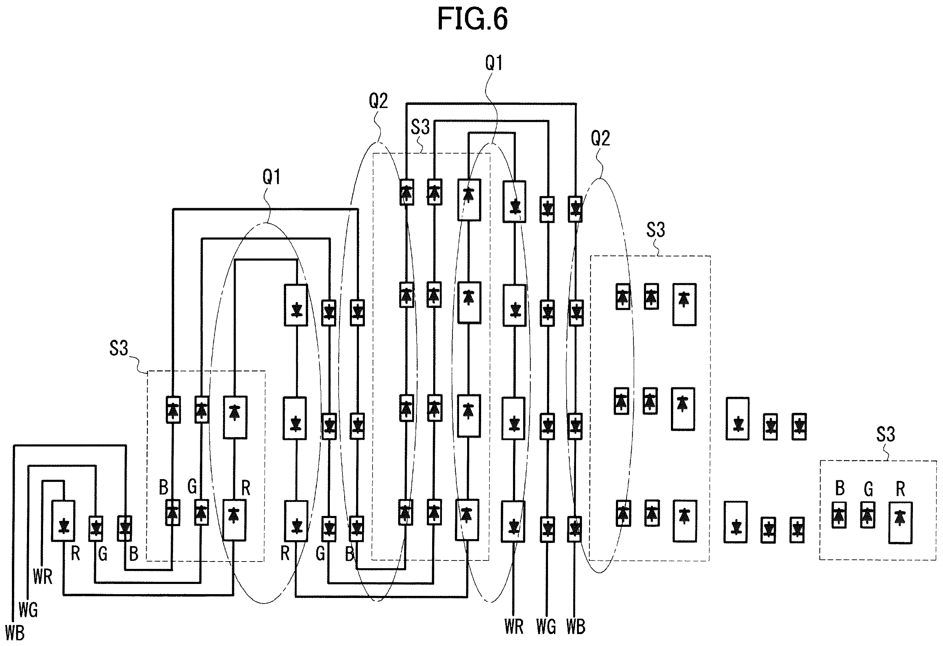

To improve the layout of light-emitting elements in FIG. 5, FIG. 6 shows a layout in which the orientation of R, G, and B LED chips is reversed by 180 degrees per column. For example, in the rectangular frames labeled "S3" in FIG. 6, the orientation of R, G, and B LED chips is reversed. By thus reversing the orientation of R, G, and B LED chips on a per column basis, the wires WR, WG, and WB can practically pass over or above the R, G, and B LED chips, rather than through the narrow spaces formed between adjacent columns as in FIG. 5. This allows wiring patterns to be formed on a single-layer substrate with ease.

In the layout of light-emitting elements shown in FIG. 6, the R LED chips in neighboring columns are positioned next to each other in the parts labeled "Q1," and the G LED chips/B LED chips in neighboring columns are positioned next to each other in the parts labeled "Q2." In other words, parts in which red light and blue light are disproportionately intense are created, resulting in unevenly noticeable red and blue stripes and degraded image quality.

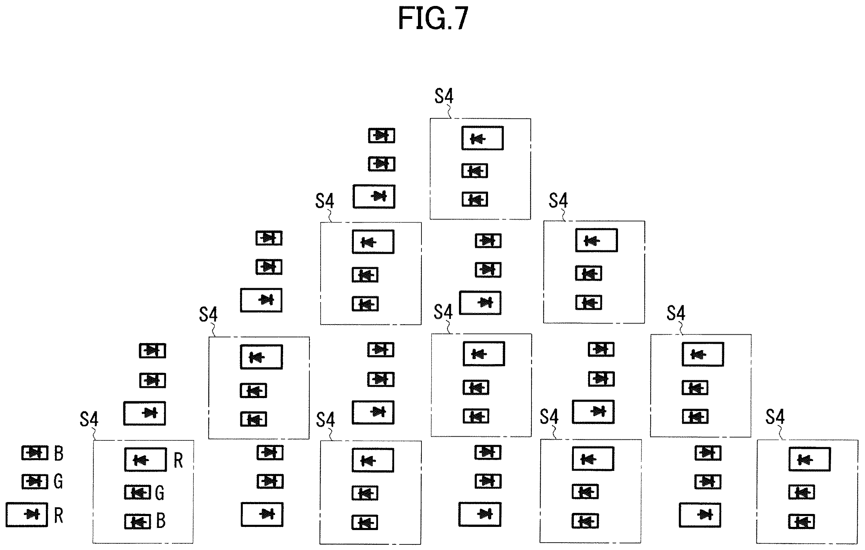

To improve the layout of light-emitting elements in FIG. 6 even more, FIG. 7 shows a layout in which R, G, and B LED chips are arranged such that their orientation coincides with the horizontal direction, that is, the row direction of the display pattern. Furthermore, the LED chips in FIG. 7 are arranged such that their orientation is reversed relative to the R, G, and B LED chips positioned next thereto. In the frames labeled "S4" in FIG. 7, the orientation of R, G, and B LED chips is reversed.

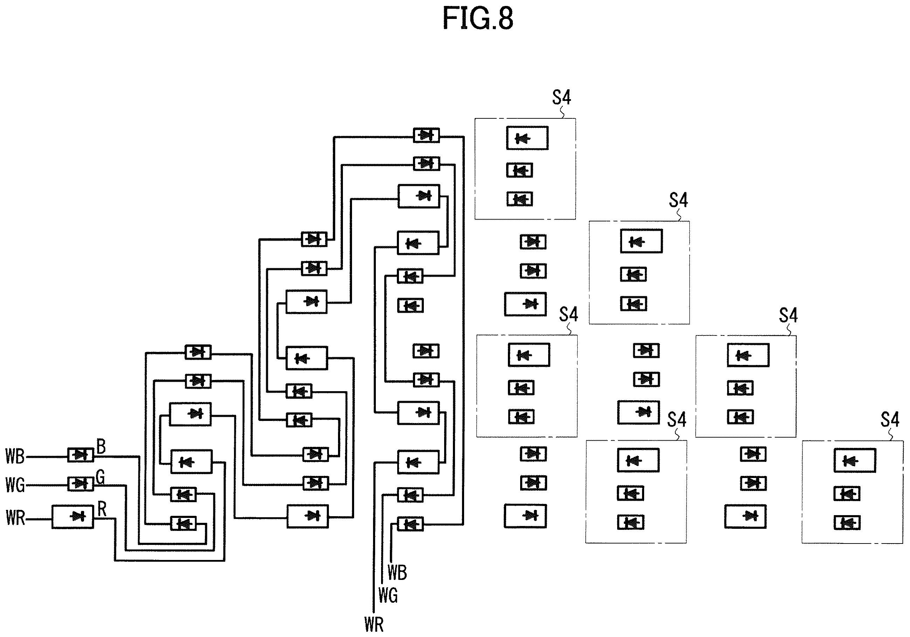

FIG. 8 shows an example wiring pattern that may be applied when LED chips are laid out as shown in FIG. 7. The wires WR, WG, and WB are routed in a single stroke so as to connect the R, G, and B LED chips in series. Taking into account the forward voltage Vf of the LED chips, it is reasonable to drive approximately 10 to 15 LED chips (that is, connect approximately 10 to 15 LED chips in series) per wire. By thus arranging R, G, and B LED chips such that their orientation is reversed or altered, compared to FIG. 6, it is possible to prevent or substantially prevent a situation in which color is distributed unevenly and red and blue stripes are excessively noticeable, and form wiring patterns relatively easily using a single-layer substrate.

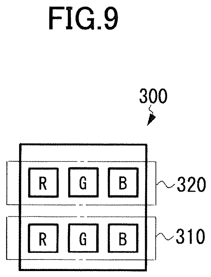

Although FIG. 5, FIG. 6, and FIG. 7 have shown example layouts of R, G, and B LED chips, these LED chips may be replaced with 6-terminal LED packages incorporating three R, G, and B LEDs. FIG. 9 shows a bottom view of a 6-terminal LED package 300. The bottom surface of the 6-terminal LED package 300 is formed with three R, G, and B LEDs' respective anode electrodes 310 and cathode electrodes 320. Provided that electrodes are laid out thus in the 6-terminal LED package 300, R, G, and B LED chips on a circuit substrate may be replaced with 6-terminal LED packages so as to match the layout of the R, G, and B LED chips' electrodes.

Although embodiments of the present disclosure have been described in detail above, the present disclosure is by no means limited to the specifics of the above embodiments, and a variety of alterations and changes may be made within the scope of the accompanying claims.

## Claims

1. A display device comprising:
a plurality of light-emitting elements; and
a circuit substrate with a surface configured for mounting the plurality of light-emitting elements,
wherein the plurality of light-emitting elements are arranged on the circuit substrate to form a fixed display pattern, and
wherein part or all of the plurality of light-emitting elements are connected in series via wires.

2. The display device according to claim 1, wherein the plurality of light-emitting elements at least include:
an R light-emitting element configured to emit red light;
a G light-emitting element configured to emit green light; and
a B light-emitting element configured to emit blue light,
wherein a plurality of said R light-emitting elements are connected in series via a first wire,
wherein a plurality of said G light-emitting elements are connected in series via a second wire, and
wherein a plurality of said B light-emitting elements are connected in series via a third wire.

3. The display device according to claim 2, wherein the plurality of R light-emitting elements, the plurality of G light-emitting elements, and the plurality of B light-emitting elements are arranged to face a same direction.

4. The display device according to claim 2 or 3, wherein, where a first and a second set of light-emitting elements are each formed with an R light-emitting element, a G light-emitting element, and a B light-emitting element, and are located next to each other in a row direction or a column direction of the fixed display pattern, the R, G, B light-emitting elements forming one of the first and second sets are arranged to face an opposite direction relative to the other set.

5. The display device according to one of claims 2 to 4, wherein, where a first and a second set of light-emitting elements are each formed with an R light-emitting element, a G light-emitting element, and a B light-emitting element, and are located next to each other, the R, G, and B light-emitting elements forming one of the first and second sets are arranged to face an opposite direction relative to the other set.

6. The display device according to one of claims 2 to 5, wherein the circuit substrate is a single-layer substrate in which the first, second, and third wires are formed on a same surface.

7. The display device according to one of claims 1 to 6, further comprising a drive circuit configured to drive part or all of the plurality of light-emitting elements,
wherein the drive circuit turns selected light-emitting elements on or off.

8. The display device according to one of claims 2 to 7, wherein the R light-emitting element, the G light-emitting element, and the B light-emitting element are LED chips or a 6-terminal LED package.
